# EUROPEAN PATENT APPLICATION

(11) **EP 3 086 365 A1**
(43) Date of publication of application: **26.10.2016**
(21) Application number: 15164821.9
(22) Date of filing: 23.04.2015
(51) Int. Cl.: H01L 23/373

(54) **COMPENSATION OF POWER ELECTRONIC MODULE FLATNESS DEVIATIONS**

(71) Applicant: ABB Technology Oy, 00380 Helsinki (FI)
(72) Inventor: Manninen, Jorma, 00380 Helsinki (FI); Silvennoinen, Mika, 00380 Helsinki (FI); Myllykoski, Pirkka, 00380 Helsinki (FI)
(74) Representative: Kolster Oy Ab

(57) **Abstract**

A power electronic assembly comprising a power electronic module incorporating multiple of semiconductor power electronic switch components, the power electronic module comprising a base plate, the power electronic assembly comprises further a cooling arrangement for cooling the power electronic module, the cooling arrangement comprising a cooling surface adapted to be attached against the base plate of the power electronic module. The power electronic assembly comprises further a carbon based material layer, which is arranged between the base plate of the power electronic module and the cooling surface of the cooling arrangement the carbon based material layer being adapted to compensate flatness deviations of the base plate of the power electronic module and to transfer heat from the power electronic module to the cooling arrangement.

## Description

### FIELD OF THE INVENTION

The present invention relates to power electronics components, and more particularly to compensation of the flatness deviations of the bottom plates of power electronic modules.

### BACKGROUND OF THE INVENTION

Power electronic modules are widely used components in which multiple of power electronic switches or devices are placed in a single module. The switches of a power electronic module are wired inside the module in specified manner such that power electronic modules can be used in different circuit structures. Such circuit structures are, for example, power stages of different power converters. For that purpose, the power electronic modules may comprise different half-bridge, full bridge or other bridge topologies in which controllable switch components are internally connected with power diodes. The power electronic modules comprise also terminals, such as control terminals and power terminals that allow connecting the modules to other required circuitry and possibly to other modules.

The components inside a power electronic module are typically mounted on a substrate that is thermally connected to the base plate of the module. The base plate is a metallic piece integrated to the bottom of the module and it is intended to be attached to a surface of a cooling member, such as heat sink. The semiconductor switches inside the modules generate heat when the switches are operated. The switched currents can be over hundreds or even thousands of amperes and the voltage blocking ability of the power semiconductors of the module is several thousand volts. These semiconductor switches are further operated at a relatively high frequency of several thousand Hertz.

To keep the temperature of the module at a tolerable range, it is known to attach the module to a heat sink. This is performed by attaching the planar surface of the baseplate to a corresponding planar surface of a heat sink. The heat transfer between the baseplate and the heat sink is enhanced by using a thermal interface material (TIM). Such material or layer is placed between the surfaces of baseplate and heat sink.

Thermal connection between two surfaces depends on several properties including their surface roughness (Ra) and surfaces' planarity. In practice the contact of two surfaces is imperfect and there are gaps filled with air in between them. Because air is poor thermal conductor the contact thermal resistance (Rth) can be reduced by making the contact surfaces perfectly smooth and planar (very expensive) and/or by replacing the air by a better thermal conducting substance.

Specific materials have been developed to fill air gaps between the surfaces in contact and to reduce contact thermal resistance. These thermal interface materials are available in different physical forms like dispensable grease or paste, various thickness rubber like pads, metal foils and so on. These materials are typically mixtures that include carrier or substrate chemical (like silicone oil or rubber) that has been filled with higher thermal conducting material like boron nitride or carbon nanotubes. Some TIMs have also phase changing property, which may be beneficial for example in cyclic operation applications. This type of TIM is proven to work well in many applications where the contact surface area is relatively small and planar like with cooling of CPUs. Another working solution for CPUs and similar small footprint and planar surfaces is the use of graphite thermal interface materials. Known graphite TIMs have high temperature conductivity and are suitable for small footprint devices due to hardness of the material.

However, the base plate footprint size of PE modules is several times larger compared to CPU's footprint size. Also the base plate surface profile is far from planar in power electronic modules. The base plate's deviation from flatness may exceed 0.1 mm (>100 µm) over 50mm length. This initial out-of-planarity causes uneven contact pressure at module mounting. Temperature gradient, power cycling and coefficient of thermal expansion differences within the materials of PE module cause dynamic variation to the thermal interface shape. This dynamic behavior causes complex deformation scenario to the thermal interface, which loads the TIM, and in many cases destroys TIM's capability to carry out the heat conduction function. For greases this means "pump-out" where grease is leaking away and for foils this means rupture and dropping pieces of foil. The above power cycling refers to uses of the power electronic module in which the loading of the module is periodical. The periodical or cyclic loading means further that the temperature of the module changes according to the cyclic loading.

The problem is that power electronic module's cooling recedes with time because of reducing thermal contact between the module's base plate and adjacent cooling surface of the heat sink. Power electronic module operation induces thermo-mechanical forces that deform the base plate that leads to deformation of thermal interface material. This in turn may increase thermal resistance in base plate - heat sink interface, which causes power electronic module chip temperatures to rise and the module to fail early.

In addition to the dynamics induced by power cycling, it has been noticed that the PE module experiences permanent deformation during operation. The consequence is that TIM must be able to adhere to not only dynamics but also the changes in static shape of thermal interface.

### BRIEF DESCRIPTION OF THE INVENTION

An object of the present invention is to provide a power electronic assembly and a method for producing the assembly so as to solve the above problems. The objects of the invention are achieved by an assembly and method which are characterized by what is stated in the independent claims. The preferred embodiments of the invention are disclosed in the dependent claims.

The invention is based on the idea of employing a carbon based material layer for compensating the power electronic modules flatness deviations and as a thermal interface between the base plate of a power electronic module and a cooling arrangement. It has been found out experimentally that carbon based materials are able to withstand the high power cycling and the deformations of the base plate of the power electronic module without noticeable changes in the heat transferring properties.

A carbon based material layer can be manufactured to have a low value of hardness and thereby it is able to adapt sufficiently to the deformed base plate filling possible gaps that are formed when the base plate has twisted or bent. Further, in addition to the low hardness, the carbon based material layer can be produced with a sufficient thickness which in turn also helps in filling the gaps that are possibly formed during the use of the power electronic module.

The prior known thermal interface materials fail to provide a structure which withstands the mechanical stresses that flatness deviations generate to TIM during the cyclic use of the power electronic module. With the carbon based material layer the heat transfer from the power electronic module to the cooling arrangement is effective even if the base plate of the module undergoes changes in shape.

### BRIEF DESCRIPTION OF THE DRAWINGS

In the following the invention will be described in greater detail by means of preferred embodiments with reference to the attached drawings, in which
Figure 1 shows a basic structure of a power electronic assembly of an embodiment of the invention with parts of the structure separated, and
Figure 2 shows the basic structure of Figure 1 as assembled.

### DETAILED DESCRIPTION OF THE INVENTION

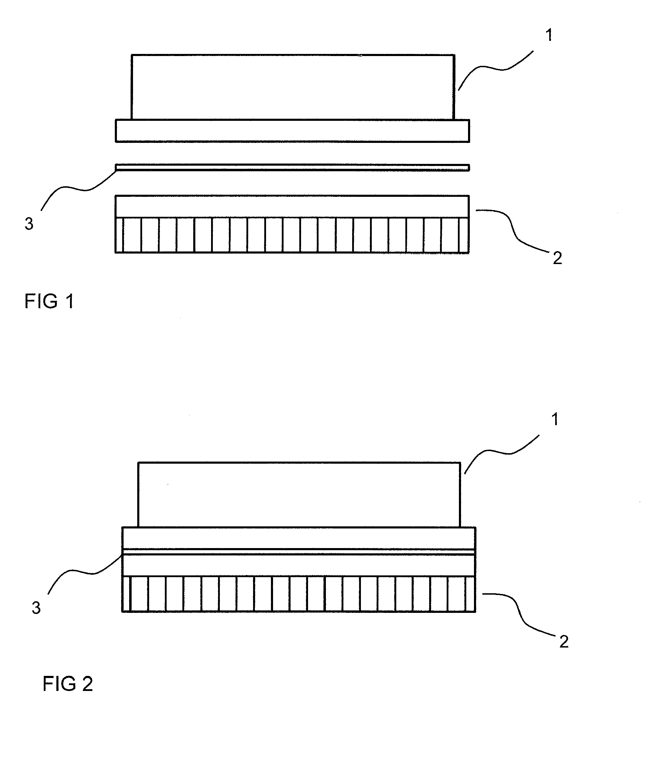

Figures 1 and 2 show a basic structure of a power electronic assembly according to an embodiment. In Figure 1 the main parts of the structure are shown as separated from each other whereas in Figure 2, the assembly is completed. The power electronic assembly comprises a power electronic module 1, cooling arrangement 2 and a carbon based material layer 3. The power electronic module is a component enclosing multiple of power electronic switches. Such modules are used in building power electronic devices which large currents are switched and which use high voltages. Typical way of operating such power semiconductor switches is to have the component either fully conducting or blocking such that current is flowing through the component only when the voltage across the component is close to zero. Although the components are controlled in such a manner, that losses are minimized, some losses are incurring both during the switching instants and during conduction. The losses of the switch components cause the module to generate heat which can be detrimental to the components if not removed from the module. The Figures 1 and 2 are presented as examples for better understanding the idea of the invention. It should be noted that the Figures 1 and 2 do not present the components of the assembly in scale. For example, the carbon based material layer is shown as a thick block in the Figures for illustrative purposes.

For removing the heat from the modules, the modules are typically structured internally in such a manner that the heat is conveyed to the base plate of the module and the temperature of the switch components can be kept within allowable limits by removing the heat from the component through the base plate. The base plate is integral part of the module and is typically metallic to enable to transfer heat via the base plate. The physical length of the base plate is in the range of hundreds of millimetres.

For removal of the heat the bottom plate is mechanically connected to a mating surface of a cooling arrangement. The cooling arrangement thus has a surface that can receive the heat from the power electronic module and to further transfer the heat to a heat transfer medium, which may be liquid or air. In liquid cooled cooling arrangements a cooling liquid is flowing in channels or piping inside a metallic block near the cooling surface. In air cooled cooling arrangements the cooling arrangement comprises a large surface area in connection with surrounding air. The heat is removed to the surrounding air from the surface of the cooling arrangement and typically a large surface are is obtained by using fins or ribs and the removal of heat may be increased by using blowers to keep the air moving in the fins or ribs.

According to the present invention, the power electronic assembly comprises a carbon based material layer, which is arranged between the base plate of the power electronic module and the cooling surface of the cooling arrangement.

The carbon based material is preferably in form of separate layer, that can be put between the base plate and cooling surface during the installing of the assembly. The carbon based material is preferably in form of a soft layer having a thickness ranging from 75 µm to 250 µm. The carbon based material is preferably natural graphite, pyrolytic graphite or synthetic graphite.

The softness and thickness of the material allows it to adapt and fill sufficiently gaps between surfaces of the base plate of the power electronic module and the cooling surface of the cooling arrangement during the attachment of the module to the cooling surface.

Power electronic module operation and power cycling during the operation causes base plate to bend and/or twist. This means that distance between the power electric module base plate and the cooling surface varies thus causing varying thermal resistance between the parts. However, the material described above has specific properties that compensate the downside effects of the deforming base plate to power electronic module cooling. These material properties include a sufficient initial thickness that's case dependent and very low hardness (less than 10 at Shore 00) allow the material to adapt and fill gaps between surfaces of the base plate of the power electronic module and the cooling surface.

Additional benefit of carbon based material's very low hardness is that the power electronic module fixing screws need no retightening after assembly. There will be hardly any remaining tension in the assembly that could release over time and cause loose fastenings.

Further, the carbon based material has a sufficiently high in-plane thermal conductivity (>200 W/mK) and through-thickness thermal conductivity (> 3 W/mK). During operation the combined effect of in-plane and through-thickness conductivities effectively balances the local thermal resistance increase caused by the air gaps that may be formed.

The carbon layer contains small enough (nano) particles that can penetrate and fill surface structures of base plate and cooling surface. Further, carbon materials, especially graphite, have good lubrication properties compared to metals, for example. This property allows the carbon layer to withstand mechanical forces related to deformation of the power electronic module during assembly and operation. The material stays in place and it doesn't tear into pieces.

The power electronic assembly is typically employed in a power electronic device. The power electronic device of the invention comprises one or more power electronics assemblies of the invention. A power electronic device is, for example, a converter, an inverter, a frequency converter or any other high-power device. Typically a power electronics device is a device that outputs controlled voltage or current to be supplied to a load. The power electronic assembly contains electrical terminals, such as control terminals and output terminals, with which the power electronics assembly can be coupled to other circuit structures and to enable operation of the circuit.

The method of the invention enables to produce the power electronic assembly. In the method, a power electronic module and a cooling arrangement are provided. The power electronic module comprises a base plate and the cooling arrangement comprises a cooling surface. In the method, a carbon based layer is provided between the base plate of the power electronic module and the cooling surface of the cooling arrangement. The power electronic module is further fastened to the cooling arrangement using fastening means. The fastening means are preferably screws or bolts with which components of the assembly are held firmly together. The screws or bolts are tightened to a specified torque which depends on the module and is typically given by the manufacturer of the power electronic module. Typically the power electronic module comprises through holes through which bolts can be assembled. The cooling arrangement has corresponding threaded holes to which the bolts can attach such that the mating surfaces are firmly against each other. The assembly of the invention does not require any modifications to the base plate, cooling surface or to fastening of the module and the cooling arrangement.

According to an embodiment, the thickness of the carbon based layer varies such that the layer is thinner in the areas near the fixing points of the module and the cooling arrangement than in the locations further away from the fixing points. With such a non-uniform layer, the pressure between the surfaces is higher in the center area of the surfaces. This further means that the ability of the material to fill gaps formed during the use of the power electronic assembly is increased.

Joint effect of the above mentioned properties make carbon an excellent thermal interface material between power electronic module base plate and a cooling surface of a cooling arrangement. This type of material has very good heat transfer properties and it is proven to have superior service life too.

It has been found out that carbon based TIM materials offer similar heat conducting properties to metallic foils, thermal greases and phase change TIMs. Decisive advantage of carbon based TIM, especially graphite TIM over other alternatives is its ability to endure shear loads and maintain good enough thermal contact. Shear loads are caused by power cycling and mismatches of coefficients of thermal expansion over the thermal interface.

It will be obvious to a person skilled in the art that, as the technology advances, the inventive concept can be implemented in various ways. The invention and its embodiments are not limited to the examples described above but may vary within the scope of the claims.

## Claims

1. A power electronic assembly comprising a power electronic module incorporating multiple of semiconductor power electronic switch components, the power electronic module comprising a base plate,
the power electronic assembly comprises further a cooling arrangement for cooling the power electronic module, the cooling arrangement comprising a cooling surface adapted to be attached against the base plate of the power electronic module, wherein
the power electronic assembly comprises further a carbon based material layer, which is arranged between the base plate of the power electronic module and the cooling surface of the cooling arrangement the carbon based material layer being adapted to compensate flatness deviations of the base plate of the power electronic module and to transfer heat from the power electronic module to the cooling arrangement.

2. A power electronic assembly according to claim 1, wherein the carbon based material layer is a separate layer of natural graphite, pyrolytic graphite or synthetic graphite.

3. A power electronic assembly according to claim 1 or 2, wherein the thickness of the carbon based material is in the range of 75 µm to 250 µm.

4. A power electronic assembly according to claim 1, 2 or 3, wherein the hardness of the carbon based material layer less than 10 at Shore 00.

5. A power electronic assembly according to any one of the previous claims 1 to 4, wherein at least one of the multiple of semiconductor power electronic components of the power electronic module is rated to a current in the range of hundreds of amperes.

6. A power electronic assembly according to any one of the previous claims 1 to 5, wherein the length of the base plate of the power electronic module is in the range of over 100 millimeters.

7. A power electronic device comprising one or more power electronic assemblies according to any one of the previous claims 1 - 6.

8. A power electronic device according to claim 7, wherein the power electronic device is a frequency converter.

9. A method of producing a power electronic assembly comprising the steps of
providing a power electronic module incorporating multiple of semiconductor power electronic switch components, the power electronic module comprising a base plate,
providing a cooling arrangement for cooling the power electronic module, the cooling arrangement comprising a cooling surface adapted to be attached against the base plate of the power electronic module,
providing a carbon based layer between the base plate of the power electronic module and the cooling surface of the cooling arrangement, and
fastening the power electronic module to the cooling arrangement using fastening means.
